# NEW EUROPEAN PATENT SPECIFICATION

(11) **EP 1 179 516 B2**
(45) Date of publication and mention of the opposition decision: **31.01.2007**
(45) Mention of the grant of the patent: 09.07.2003
(21) Application number: 01203580.4
(22) Date of filing: 02.02.1999
(51) Int. Cl.: C03C 17/34, C03C 17/36, C23C 14/56

(54) **Method of coating both sides of a glass substrate and apparatus**
Verfahren zur Beschichtung von beiden Seiten eines Glassubstrats
Méthode de revêtement des deux côtés d'un substrat en verre

(30) Priority: 21.12.1998 US 113259
(43) Date of publication of application: 13.02.2002
(62) Divisional of application: 99905630.2
(73) Proprietor: Cardinal CG Company, Eden Prairie, Minnesota 55344 (US)
(72) Inventor: Krisko, Annette, Prairie de Sac, Wisconsin 53578 (US); Bond, Bob, Spring Green, Wisconsin 53588 (US); Stanek, Roger, Spring Green, Wisconsin 53588 (US); Pfaff, Gary, Spring Green, Wisconsin 53588 (US); Hartig, Klaus, Avcoa, Wisconsin 53506 (US)
(74) Representative: Howe, Steven

(56) References cited:
- WO-A-92/17621
- DE-A- 4 313 284
- Prospekt über das Hochrate-Zerstäubungssystem zur Zweiseitenbeschichtigung "HZS-04" des VEB ELEKTROMAT DRESDEN, Erscheinungsjahr 1986 (Druck-Nr. 05/005/86

## Description

The present invention provides a method of coating both sides of a glass substrate.

Keeping windows and other glass surfaces clean is a relatively expensive, time-consuming process. While cleaning any individual window is not terribly troublesome, keeping a larger number of windows clean can be a significant burden. For example, with modern glass office towers, it takes significant time and expense to have window washers regularly clean the exterior surfaces of the windows.

Windows and other glass surfaces can become "dirty" or "soiled" in a variety of ways. Two of the primary manners in which windows can collect dirt involve the action of water on the glass surface. First, the water itself can deposit or collect dirt, minerals or the like onto the surface of the glass. Obviously, dirty water landing on the glass will leave the entrained or dissolved dirt on the glass upon drying. Even if relatively clean water lands on the exterior surface of a window, each water droplet sitting on the window will tend to collect dust and other airborne particles as it dries. These particles and any other chemicals which become dissolved in the water will become more concentrated over time, leaving a characteristic spot or drying ring on the glass surface.

The second way in which water tends to give a window or other glass surface a soiled or less attractive appearance is tied to an attack on the glass surface itself. As a droplet of even relatively clean water sits on a glass surface, it will begin to leach alkaline components from the glass. For a typical soda lime glass, the soda and lime will be leached out of the glass, increasing the pH of the droplet. As the pH increases, the attack on the glass surface will become more aggressive. As a result, the glass which underlies a drying water droplet will become a little bit rougher by the time the water droplet completely dries. In addition, the alkaline components which were leached out of the glass will be redeposited on the glass surface as a drying ring. This dried alkaline material not only detracts from the appearance of the glass; it will also tend to go back into solution when the glass surface is wetted again, rapidly increasing the pH of the next water droplet to coalesce on the glass surface.

In storing and shipping plate glass, the presence of water on the surfaces between adjacent glass sheets is a chronic problem. One can take steps to shield the glass from direct contact with water. However, if the glass is stored in a humid environment, water can condense on the glass surface from the atmosphere.

This becomes more problematic when larger stacks of glass are collected. Large stacks of glass have a fairly large thermal mass and will take a long time to warm up. As a consequence, they will often be cooler than the ambient air when ambient temperature increases (e.g., in the morning), causing moisture in the air to condense on the surface of the glass. Due to limited air circulation, any moisture which does condense between the sheets of glass will take quite a while to dry. This gives the condensed moisture a chance to leach the alkaline components out of the glass and adversely affect the glass surface. The rate of attack can be slowed down somewhat by applying an acid to the surface of the glass. This is commonly done by including a mild acid, e.g., adipic acid, in the separating agent used to keep glass sheets from sticking to and scratching one another.

A number of attempts have been made to enable a glass sheet to keep a clean appearance longer. One avenue of current investigation is a "self-cleaning" surface for glass and other ceramics. Research in this area is founded on the ability of certain metal oxides to absorb ultraviolet light and photocatalytically break down biological materials such as oil, plant matter, fats and greases, etc. The most powerful of these photocatalytic metal oxides appears to be titanium dioxide, though other metal oxides which appear to have this photocatalytic effect include oxides of iron, silver, copper, tungsten, aluminum, zinc, strontium, palladium, gold, platinum, nickel and cobalt.

While such photocatalytic coatings may have some benefit in removing materials of biological origin, their direct impact on other materials is unclear and appears to vary with exposure to ultraviolet light. As a consequence, the above-noted problems associated with water on the surface of such coated glasses would not be directly addressed by such photocatalytic coatings.

A number of attempts have been made to minimize the effect of water on glass surfaces by causing the water to bead into small droplets. For example, U. S. Patent 5,424,130 (Nakanishi, et al) suggests coating a glass surface with a silica-based coating which incorporates fluoroalkyl groups. The reference teaches applying a silicone alkoxide paint onto the surface of the glass, drying the paint and then burning the dried paint in air. Nakanishi, et al. stress the importance of substituting part of the non-metalic atoms, i.e., oxygen in a layer of SiO₂, with a fluoroalkyl group. Up to 1.5% of the oxygen atoms should be so substituted. Nakanishi, et al. state that if less than 0.1 % of the oxygen atoms are substituted with a fluoroalkyl group, the glass won't repel water properly because the contact angle of water on the glass surface will be less than 80°.

Such "water repellent" coatings do tend to cause water on the surface of the glass to bead up. If the coating is applied to an automobile windshield or the like where a constant flow of high velocity air is blowing over the surface, this water beading effect can help remove water from the glass surface by allowing the droplets to blow off the surface. However, in more quiescent applications, these droplets will tend to sit on the surface of the glass and slowly evaporate. As a consequence, this supposed "water repellent" coating will not solve the water-related staining problems noted above. To the contrary, by causing the water to bead up more readily, it may actually exacerbate the problem.

Other silica coatings have been applied to the surface of glass in various fashions. For example, U.S. Patent 5,394,269 (Takamatsu, et al.) proposes a "minutely rough" silica layer on the surface of glass to reduce reflection. This roughened surface is achieved by treating the surface with a supersaturated silica solution in hydrosilicofluoric acid to apply a porous layer of silica on the glass sheet. By using a multi-component of sol gel solution, they claim to achieve a surface which has small pits interspersed with small "islet-like land regions" which are said to range from about 50-200 nm in size. While this roughened surface may help reduce reflection at the air/glass interface, it appears unlikely to reduce the water-related staining problems discussed above. If anything, the porous nature of this coating appears more likely to retain water on the surface of the glass. In so doing, it seems probable that the problems associated with the long-term residence of water on the glass surface would be increased.

The present invention relates to methods of depositing a coating on both sides of a glass substrate.

It is known to deposit a layer on one side of a substrate by sputtering a target located on one side of the substrate. Where the other side of the substrate is to be sputter coated, it is usually necessary to reverse the orientation of the substrate, and pass this through the coating apparatus a second time.

WO 92/17621 and DE 4313284 disclose methods in which disk substrates are held in a vertical arrangement on substrate carriers that move through the chamber along with the substrates as targets provided laterally of the vertically arranged substrates are laterally sputtered.

According to a first aspect of the present invention, a method of coating two sides of a single pane of glass in a single pass through a coating apparatus, comprises:
providing a sheet of glass having a clean interior surface and a clean exterior surface;
providing a sputtering line comprising at least one sputtering chamber, the sputtering line having a plurality of transport rollers for conveying the sheet of glass along the sputtering line, the sputtering line having an upper target positioned above the transport rollers, and a lower target positioned below the transport rollers;
positioning the sheet of glass on the transport rollers such that the interior surface is oriented toward the upper target and sputtering the upper target to deposit a coating directly on one of the interior surface of the glass or a film stack layer previously deposited on the interior surface of the glass; and,
positioning the sheet of glass on the transport rollers such that the exterior surface is oriented toward the lower target and sputtering the lower target to deposit a coating on one of the exterior surface of the glass or a film stack layer previously deposited on the exterior surface of the glass,
the glass being coated on both the interior surface and the exterior surface while maintaining a constant orientation wherein the interior surface is positioned above the exterior surface.

In one embodiment, the sputtering line comprises providing a series of sputtering chambers including a first, downward sputtering chamber including the upper target, and a second, upward sputtering chamber including the lower target. The sputtering of the upper target is performed while the sheet of glass is in the downward sputtering chamber and the sputtering of the lower target is performed while the sheet of glass is in the upward sputtering chamber. In an alternative embodiment, the sputtering line includes a dual direction sputtering chamber including both the upper and lower targets. The glass sheet remains in the dual direction sputtering chamber while both the upper and lower targets are sputtered.

According to a second aspect of the present invention, a coating apparatus for coating two sides of a single pane of glass in a single pass through the coating apparatus, the coating apparatus comprising a sputtering line that includes at least one sputtering chamber, the sputtering line having a plurality of transport rollers for supporting and conveying the pane of glass along the sputtering line, an upper target positioned above the transport rollers within a sputtering chamber for sputtering a coating onto the upper surface of the pane of glass and, a lower target positioned below the transport rollers within a sputtering chamber of the sputtering line for sputtering a coating onto the lower surface of the pane of glass.

The present invention will be described, by way of example, with reference to the accompanying drawings, in which:
Figure 1 is a schematic cross-sectional view of a sheet of glass bearing a coating;
Figure 2 is a schematic cross-sectional illustration of a mufti-pane insulated glass unit;
Figure 3 is a schematic cross-sectional view of a laminated window structure of the type commonly used in automobile windshields bearing a water-sheeting coating;
Figure 4 is a schematic illustration of a dual direction sputtering chamber for use in, and in accordance with, a first embodiment of the invention;
Figure 5 is a schematic illustration of a multiple-zone dual direction sputtering chamber for use, and in accordance with, another embodiment of the invention;

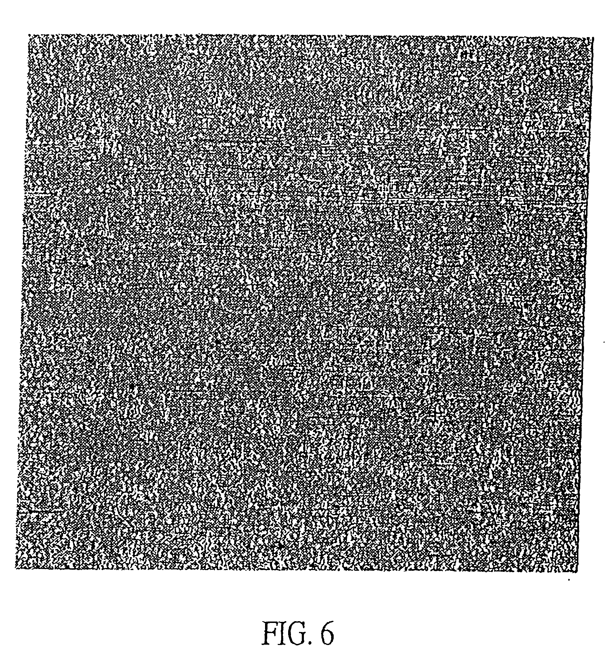

Figure 6 is an atomic force micrograph of a plain, uncoated surface of a sheet of conventional float glass;

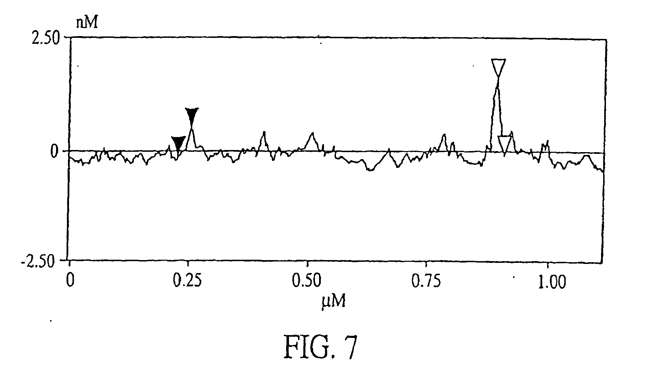

Figure 7 is a graph showing a height profile across a short length of the surface of the sheet of glass shown in Figure 6;
Figure 8 is a atomic force micrograph of a surface of a sheet of float glass bearing a water-sheeting coating;
Figure 9 is a three-dimensional representation of an area of the same sheet of float glass illustrated in Figure 8; and
Figure 10 is a graph similar to Figure 7, but showing a height profile across a short length of the surface of the water-sheeting coating shown in Figures 8 and 9.

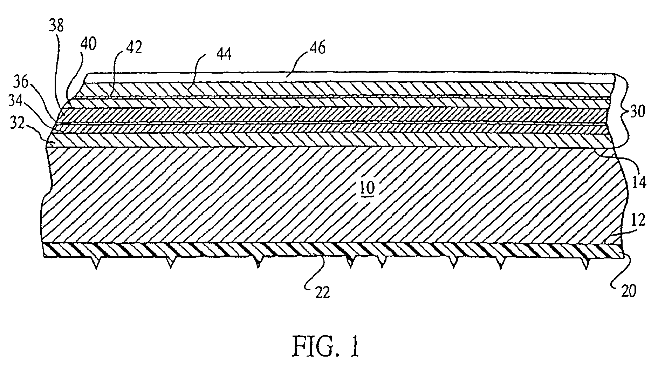

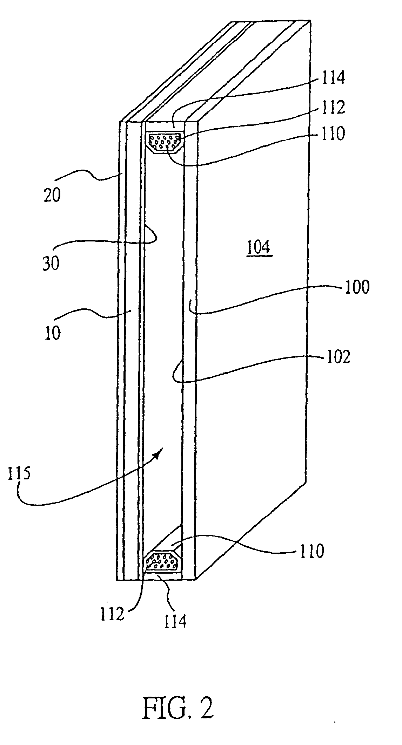

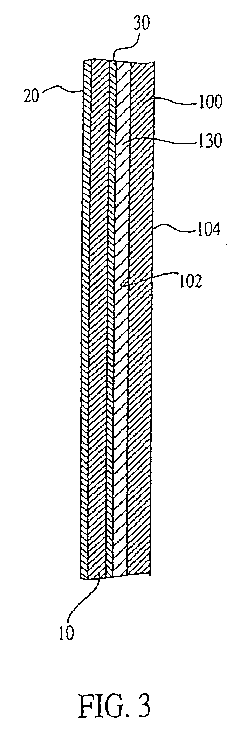

Figure 1 schematically illustrates a sheet of glass bearing a pair of coatings. The sheet of glass 10 includes an exterior face 12 and an interior face 14. (The designation of "interior" and "exterior" face in the ensuing discussion is somewhat arbitrary. It is assumed, though, that in most circumstances the exterior face will be exposed to an ambient environment wherein it may come into contact with dirt, water and the like. The interior face may also be oriented toward the same kind of ambient environment. In the embodiments illustrated in Figures 2 and 3, though, this "interior" face is actually protected and a second pane of glass stands between this interior face and the ambient environment.)

The interior face 14 of the glass 10 bears a reflective coating 30. As those skilled in the art will readily recognize, this reflective coating may take any desired form depending on the desired properties. A wide variety of such films are known in the art and the precise nature of the reflective coating 30 is beyond the scope of the present invention.

If, for example, the glass article is to be used as a mirror, the coating 30 may simply comprise a relative thick layer of a reflective metal. If so desired, a protective coating of a dielectric material may be applied over the surface of the metal opposite the surfacing contact with the glass. As is known in the art, this will help protect the metal layer from chemical and physical attack. One could also employ any of a variety of mirror coatings known in the art which comprise a layer of a dielectric on either side of a reflective metal layer; many dichroic mirrors known in the art employ such coatings.

In the example of Figure 1, the reflective coating 30 is typified as an infrared reflective coating of the type commonly used in low emissivity solar control films. Typically, such films will comprise a metal layer sandwiched between a pair of dielectric layers. This structure may be repeated to further enhance the infra-reflective properties of the film stack. One example of a useful infrared reflective film stack is disclosed in U.S. Patent 5,302,449 (Eby, et al.), the teachings of which are incorporated herein by reference.

The illustrative film stack 30 of Figure 1 includes a base coat 32 which may comprise one or more layers of dielectric materials. For example, this base coat 32 may comprise zinc oxide applied at a thickness of about 150-275 Å. A first metal layer 34 may be applied directly on top of this base coat 32. This metal may be, for example, silver applied at a thickness of between about 100 Å and about 150 Å. A second dielectric layer 38 may be applied over the first metal layer 34. The thickness of this dielectric layer 38 will depend, at least in part, on whether a second metal layer 40 will be included in the film stack. In a film stack having two metal layers, as shown, this second dielectric layer 38 may typically comprise a relatively thick layer of a metal oxide, such as 700-750 Å of zinc oxide. If so desired, a relatively thin sacrificial layer 36 may be applied between the metal layer 34 and the dielectric layer 38. This will help protect the metal layer 34 during the sputter deposition of the dielectric layer 38. The sacrificial layer 36 may, for example, comprise a layer of titanium metal applied at a thickness of 25 Å or less. This titanium metal will oxidize sacrificially during the application of a metal oxide dielectric 38, limiting any damage to underlying silver layer 34.

In the illustrated film stack, a second metal layer 40 is applied over the second dielectric layer 38. The second metal layer 40 will usually be made of the same material as is the first metal layer 34. For example, this second metal layer 40 may comprise about 125-175 Å of silver. Again, a sacrificial layer 42 of titanium or the like may be applied over the metal layer 40 to protect the metal layer during subsequent deposition of the overlying dielectrics 44 and 46. A third dielectric layer 44 is applied over the sacrificial layer 42. This dielectric layer 44 can also be a metal oxide, e.g., zinc oxide applied at about 250-300 Å. If so desired, a protective overcoat 46 of another dielectric material can be applied over the dielectric layer 44. In one preferred embodiment, th is overcoat 46 may comprise a 50-60 Å layer of Si₃N₄.

The water-sheeting coating 20 was applied to the inner surface 12 of the glass. It is preferred that this coating be applied directly on the surface of the glass sheet 12. As the glass, which will typically be a soda/lime glass, is largely formed of silica and the water-sheeting coating is also desirably formed of silica, this is believed to provide a strong bond between these two layers and may enhance the water-sheeting performance of the coating 20.

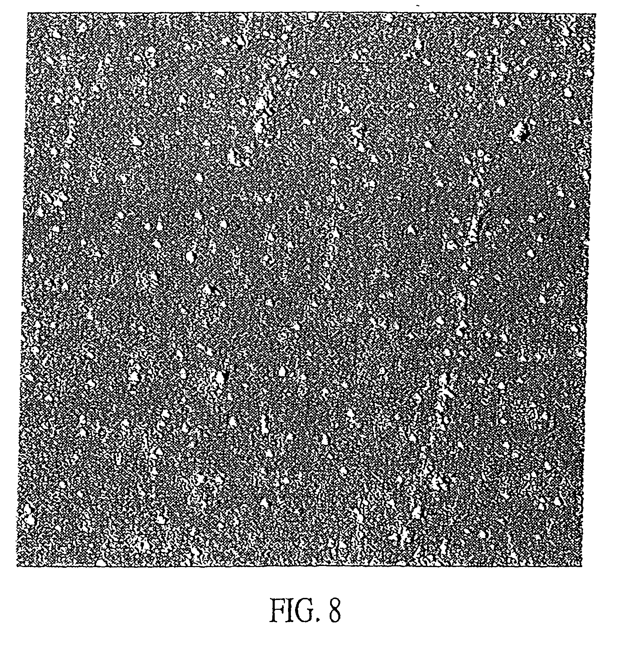

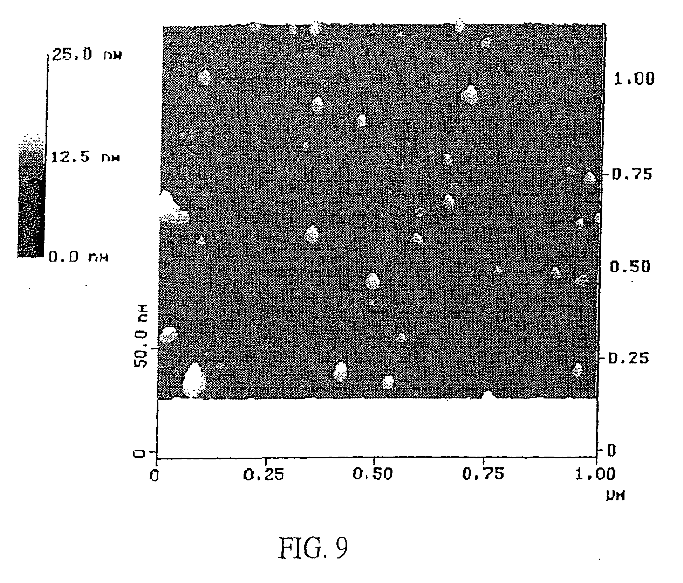

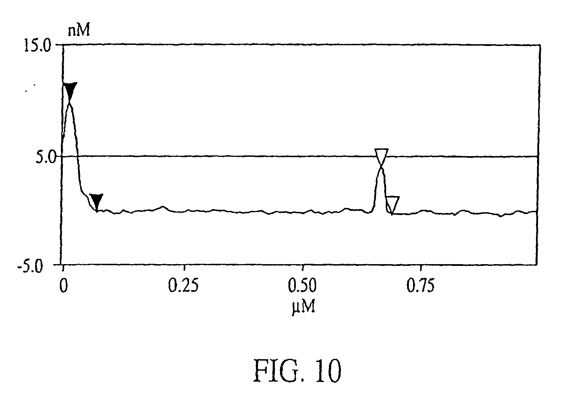

The water-sheeting coating 20 desirably comprises silica deposited directly on the exterior surface 12 of the glass 10. As will be discussed below in connection with Figures 8-10, the exterior face 22 of this coating 20 has an irregular surface. (This is schematically shown as a series of irregularly-spaced and -sized spikes on the exterior face 22 of the coating 31). Accordingly, attributing any specific thickness to this coating 20 will be inherently somewhat inaccurate. However, the coating 20 desirably has a median thickness of between about 15 Å and about 350 Å, with a range of between about 15 Å and about 150 Å being preferred. The major benefit of this coating at the least cost is believed to be evidenced at a range of about 20 Å to about 120 Å. One preferred manner in which this coating 20 may be applied to the exterior surface 12 of the glass 10 will be discussed in more detail below.

Figure 2 is a schematic illustration of a multipane insulated glass unit. Insulated glass units are well known in the art and may not be discussed in any significant detail here. Briefly, though, such an insulated glass unit would generally comprise two panes of glass 10,100 held in a spaced-apart relationship by a spacer 110. In this example, the water-sheeting coating 20 carried by the exterior surface of the glass 10 is oriented away from the second pane of glass 100 while the reflective coating 30 carried by the interior face of the glass 10 is oriented toward the second pane of glass 100. The spacer 110 is bonded on one side to the interior surface 102 of the second glass pane 100 and on the other side to the first glass pane 10. As is known in the art, the spacer may be bonded directly to the interior surface 14 of the glass 10 or the reflective coating 30 may extend out to the margins of the glass 10 and the spacer may be attached directly to that coating 30.

Typically, the spacer will be formed of metal or the like and will have a desiccant 112 retained therein. This desiccant will be allowed to communicate with the gas in the interpane space 115 to remove any moisture which may seep between the panes of glass. An exterior seal 114 may be carried around the external periphery of the spacer 110 to form a reliable gas and moisture barrier.

Figure 3 illustrates another application for a coated glass article. In this example, the glass sheet 10 is bonded to a second sheet of glass 100 by an intermediate tear-resistant plastic film 130 to form a laminated structure. Such laminated window structures are well known in the field of automobile windows. Typically, this plastic layer 130 will take the form of a relatively thick layer of polyvinylbutyral or the like which is heat-fused to the other two sheets of glass. The reflective film 30 preferably comprises a heat-temperable infrared reflective film. A variety of such films are known in the art and the precise nature of this film is beyond the scope of the present invention, but any suitable heat-temperable coating 30 may be used.

As noted above, the water-sheeting coating is applied by sputtering, as is the reflective coating 30.

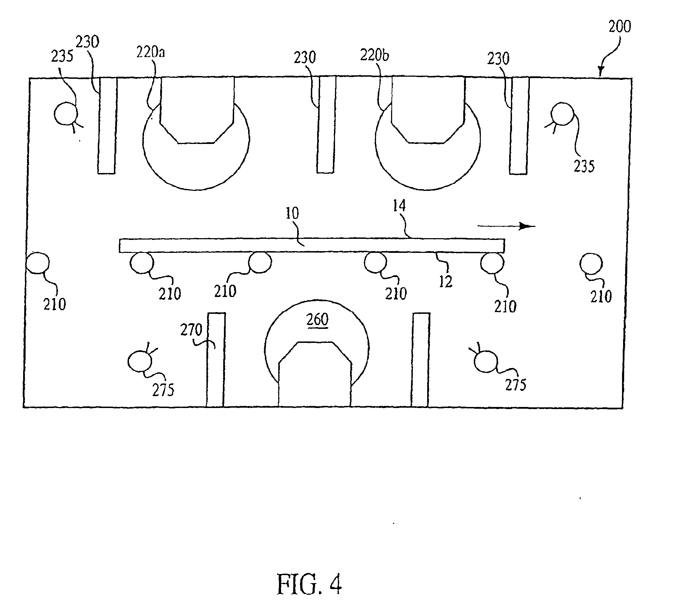

Figure 4 schematically illustrates a dual direction sputtering chamber in accordance with one embodiment of the present invention. Magnetron sputtering chambers are well known in the art and are commercially available from a variety of sources. While a thorough discussion of such magnetron sputtering chambers is beyond the scope of the present disclosure, one relatively useful structure for such a device is disclosed in U.S. Patent 5,645,699 (Sieck).

Generally speaking, though, magnetron sputtering involves providing a target formed of a metal or dielectric which is to be deposited on the substrate. This target is provided with a negative charge and a relatively positively charged anode is positioned adjacent the target. By introducing a relatively small amount of a desired gas into the chamber adjacent the target, a plasma of that gas can be established. Atoms in this plasma will collide with the target, knocking the target material off of the target and sputtering it onto the substrate to be coated. It is also known in the art to include a magnet behind the target to help shape the plasma and focus the plasma in an area adjacent the surface of the target.

In Figure 4, the sheet of glass 10 to be coated is positioned on a plurality of support rollers 210 which are spaced along the length of the sputtering chamber 200. While the precise spacing of these rollers 210 can be varied, for reasons explained more fully below, it is desired that these rollers are spaced a little bit farther apart along at least a interim length of the chamber 200 to increase the effective coating area from the lower target 260.

In the illustrated embodiment, the sheet of glass 10 is oriented to travel horizontally across these rollers, e.g., from left to right. The interior surface 14 of the glass is oriented upwardly while the exterior surface 12 of the glass is oriented downwardly to rest on the rollers 210. (While this is probably the most typical configuration, it should be understood that the relative orientation of the glass within the sputtering chamber 200 can be switched so long as the relative positions of the upper targets 200 and the lower target 260 are also reversed. As a consequence, it should be noted that designating these targets as "upper" and "lower" targets is simply for purposes of convenience and the relative orientation of these elements within the sputtering chamber can easily be reversed if so desired.)

The sputtering chamber 200 shown in Figure 4 includes two spaced-apart upper sputtering targets 220a and 220b. While these targets can be planar targets, they are illustrated as being so-called rotary or cylindrical targets. These targets are arranged generally parallel to one another with a plurality of anodes 230 extending horizontally and generally parallel to these targets. As suggested in U.S. Patent 5,645,699, an intermediate anode 230 may also be positioned between these two targets.

A gas distribution system is used to supply the sputtering gas to the chamber adjacent the targets 220a and 220b. While a variety of gas distribution systems are known in the art, this distribution system may simply comprise a pair of pipes 235 with a plurality of spaced-apart openings or nozzles oriented generally toward the target.

The use of multiple targets positioned above a glass substrate in a magnetron sputtering chamber is fairly conventional in the field. The unique aspect of the sputtering chamber 200 Figure 4, though, is the presence of the "lower" target 260. This target is the target used to sputter the water-sheeting coating 20 of the invention directly on the exterior surface 12 of the glass. As with the upper targets 220a and 220b, the lower target 260 is provided with at least one, and preferably two, anodes 270 in sufficient proximity to establish a stable plasma. The gas distribution pipes 235 shown adjacent the upper targets 220a and 220b are undesirably far from the lower target 260 and the intermittent presence of the glass 10 will effectively divide the sputtering chamber 200 into two separate functional areas. Accordingly, it is preferred to have separate gas distribution pipes 275 positioned beneath the gas adjacent the lower target 260 to ensure a consistent supply of gas for the plasma adjacent the target. If so desired, the lower pipes 275 and the upper pipes 235 may be a part of the same gas distribution system, i.e., both sets of pipes can be connected to a single gas supply.

The nature of the gas supplied by the lower pipes 275 will depend at least in part on the nature of the sputtering target 260. In conventional magnetron sputtering, the target must serve as a cathode. Due to the dielectric nature of SiO2, it can be exceedingly difficult to reliably sputter using a silica target. As a consequence, it is preferred that the target comprise silicon metal rather than silica. The material actually deposited on the exterior surface 12 of the glass can be converted to silica by including oxygen in the gas supplied through the lower gas distribution pipes 275.

While the successive sheets of glass 10 will effectively divide the sputtering chamber, this does not preclude gas introduced in one area of the chamber from travelling elsewhere in the chamber. As it is preferred that the lower target 260 comprise silicon metal sputtered in an oxidizing atmosphere, it is important that the sputtering of the upper targets 220a and 220b not be adversely affected by the presence of any excess oxygen which may be introduced through the lower pipes 275. This may effectively preclude the use of this dual direction sputtering chamber 200 to deposit a water-sheeting coating 20 on one side of the glass sheet and an oxygen-sensitive metal on the other surface.

More advantageously, the dual direction sputtering chamber of Figure 4 can be used to deposit a dielectric layer on the interior surface 14 of the glass and the silica water-sheeting coating 20 on the exterior surface 12 of the glass in a single chamber. The sputtered dielectric may be a nitride or the like so long as the introduction of some metal oxide into the nitride being deposited will not adversely affect the coating being applied. Ideally, though, the dielectric being applied to the interior surface 14 is an oxide (or at least a partial oxide) so that any commingling of the gases introduced through the two sets of pipes 235 and 275 will not adversely affect either the dielectric layer or the water-sheeting coating. For example, one or both of the targets 220a and 220b may be made of titanium metal or TiOx (where 1<X<2) and the gas introduced through both sets of gas distribution pipes 235 and 275 may comprise an appropriately balanced mixture of argon and oxygen.

In conventional magnetron sputtering chambers, the spacing of the rollers 210 used to support the glass is kept fairly small to permit smaller glass substrates to be processed on the line without any significant risk of having the glass fall between the rollers. In order to minimize the interference of the rollers in applying the water-sheeting coating on the exterior surface 12 of the glass, though, this spacing may be increased. The maximum safe spacing will need to be determined on a case-by-case basis for a given range of anticipated glass sizes. However, the larger the spacing between the rollers disposed in the path from the lower target 260 to the exterior surface 12 of the glass, the greater the percentage of the sputtered silica which will be deposited on the glass. Of course, the rollers in other areas of the sputtering apparatus can be maintained at their normal spacing. It may be desirable to make a few of the rollers in the dual direction sputtering chamber 200 easily removed so the chamber can be converted from the illustrated configuration to a more conventionally operated chamber coating only one side of the glass and having rollers spaced more closely together.

Instead of changing the spacing between the rollers, the rollers could instead be made smaller in diameter. Conventional rollers are hollow metal tubes. If so desired, the smaller diameter rollers can be stiffened, e.g., by filling them with a rigid foam. In order to maintain the same transport speed of the glass along the support, these smaller-diameter rollers would have to be turned more rapidly, e.g., by means of a pair of gears having the desired gear ratio.

The rollers 210 can be of any conventional structure. It has been found that good results can be obtained by employing cylindrical aluminum rollers about which a rope of Kevlar™ is spirally wound, with the Kevlar™ providing the surface with which the glass is in direct contact.

In some specific applications, the dual direction sputtering chamber 200 of Figure 4 may be sufficient to apply the entire desired coating to both the interior and exterior surfaces of the glass. More often, though, the sputtering chamber 200 would be part of a sputtering line comprising a series of sputtering chambers. Each sputtering chamber in the line could include both an upper target and a lower target, but in most conventional applications the film stack applied to the upper surface of the glass will be more complex (i.e. will comprise a series of distinct layers of varying composition) and thicker than is the water-sheeting coating of the invention. As a consequence, a majority of the sputtering chambers can comprise conventional, downward sputtering chambers having only an upper target, with no target positioned beneath the supports.

If the sputtering line comprises a combination of downward sputtering chambers and dual direction sputtering chambers 200, the position of the dual direction chambers along the sputtering line can be varied. If the water-sheeting coating of the invention is applied by sputtering a silicon-containing target (e.g., one formed primarily of silicon or formed of silicon doped with aluminum) in an oxidizing atmosphere, one should not attempt to deposit an oxidizable metal layer (e.g., an infrared reflective silver layer of the type conventionally used in low emissivity film stacks) on the upper surface of the glass in the same chamber. Accordingly, at least those chambers used to sputter a metal layer may be operated as a downward sputtering chamber by omitting the lower target. It would be possible, though, to deposit a metal oxide (e.g., SiO₂, ZnO or SnO₂) on the upper surface of the glass in the same chamber.

Conventional wisdom would suggest to one skilled in the art that the water-sheeting coating of the invention be applied in the first sputtering chamber or, if necessary, the first several sputtering chambers to make sure that the water-sheeting coating is applied before the glass surface is damaged or soiled by contact with the rollers supporting the glass within the chambers. Quite surprisingly, it has been found that the opposite is true - the water-sheeting coating of the invention is optimally applied in the last sputtering chamber. If more than one dual direction sputtering chamber 200 is necessary to deposit a sufficiently thick water-sheeting coating without unduly slowing down glass speed through the sputtering line, the water-sheeting coating is optimally applied in the last few sputtering chambers.

If the water-sheeting coating is applied at the beginning of the sputtering line, the majority of the exterior surface of the glass will exhibit the desired water-sheeting properties. However, the margins of the glass may not exhibit these improved properties on a consistent basis. This is believed to be due to a slight overspray of the coating applied to the upper surface of the glass after deposition of the water-sheeting coating, wherein a very small amount of the material being applied to the upper surface will drift down to the lower surface and overlie the water-sheeting coating adjacent the edges of the glass sheet. While this oversprayed coating is thin enough as to have no readily discernable effect on the optical properties of the glass, this virtually invisible coating compromised the benefits of the water-sheeting coating around the edges of the glass. By applying the silica to the exterior surface of the glass toward the end of the sputtering line, the amount of overspray deposited on top of the silica coating can be minimized and the beneficial water-sheeting effects of this coating can be preserved.

A dual direction sputtering chamber 200 such as that shown in Figure 4 is believed to minimize the cost and maximize production efficiency in applying coatings to both sides of the sheet of glass.

As the glass substrate moves through the chamber, there will be times when the glass does not effectively shield the upper targets 200a and 200b from the lower target 260 or vice versa. As a consequence, material from the upper targets will be deposited on the lower target and material from the lower target can be deposited on one or both of the upper targets. The sputtering chamber 200 of Figure 4 is ideal if the upper targets 220a, 220b and the lower target 260 have substantially the same composition. If the upper targets have a different composition from the lower target, though, the cross-contamination of the different targets can lead to problems in sputtering or in maintaining consistent product quality.

At least in theory, this problem may be overcome by independently controlling the power supplied to each of the sputtering targets to ensure that each target is sputtering only when the glass is positioned to shield the upper and lower targets from one another. Current commercially available power supply controllers are not configured in this fashion, however. Furthermore, the control logic for such an arrangement can be unduly difficult if the sputtering line is used to coat glass substrates of varying sizes rather than a consistent size.

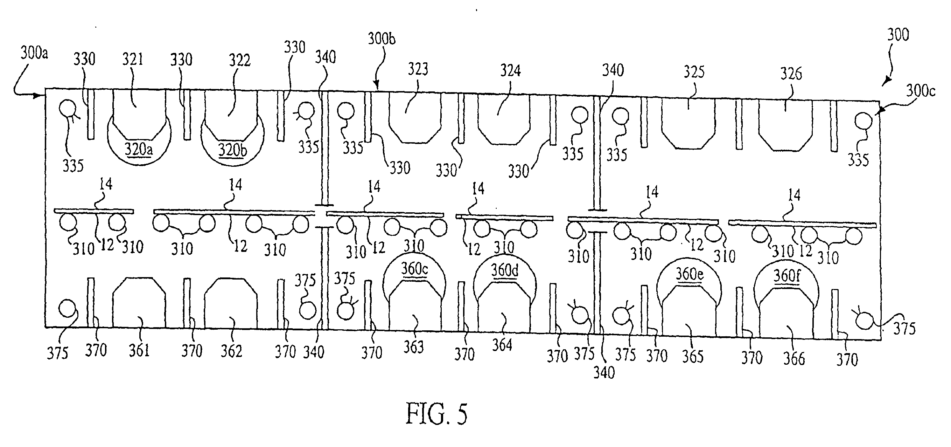

Figure 5 illustrates another embodiment of the invention, one possible sputtering chamber 300 which can be used to coat both the interior surface 14 and the exterior surface 12 of the substrate in a single pass without significant cross contamination of the sputtering targets. Elements serving an analogous function to elements shown in Figure 4 bear like reference numbers, but indexed by 100, e.g., the upper gas distribution pipes 335 of Figure 5 are functionally analogous to the upper gas distribution pipes 235 of Figure 4.

The sputtering chamber 300 of Figure 5 is effectively divided into three coating zones 300a, 300b and 300c by a pair of barriers 340. Some fraction of the gas in one coating zone may flow into another coating zone, so it is best to use a similar atmosphere in all three zones. However, the barriers 340 serve to effectively limit the amount of material sputtered in one coating zone which lands on a target in another coating zone.

In the embodiment of Figure 5, each of the three coating zones 300a-300c is adapted to hold up to four targets, with two targets positioned above the substrate and two positioned below the substrate. Hence, there are six upper target mounts 321-326 positioned above the path of the glass and six lower target mounts 361-366 positioned beneath the path of the glass. This allows maximum flexibility in using this single multi-zone sputtering chamber 300 to manufacture products having different properties. Figure 5 schematically illustrates each of the upper target mounts 321-326 vertically aligned with one of the lower target mounts 361-366, respectively. It should be understood, however, that the targets need not be vertically aligned in this fashion and may be more advantageously positioned in a horizontally staggered arrangement.

In the configuration shown in Figure 5, the first coating zone 300a has two upper targets (320a and 320b), but no lower targets on the lower target mounts 361 or 362. While a sputtering gas should be supplied to the upper gas distribution pipes 335 and power should be supplied to the upper anodes 330 in the first coating zone, there is no need to deliver any gas to the lower gas distribution pipes 375 or any power to the lower anodes 370. The second coating zone 300b has two lower targets 360c and 360d, but neither of the upper target mounts 323 and 324 carry sputtering targets. Similarly, the third coating zone 300c has two lower targets 360e and 360f, but neither of the uppertarget mounts 325 and 326 carry sputtering targets. Optimally (as discussed above), the first coating zone 300a is used to apply the outermost layer of the reflective film stack carried by the interior surface 14 of the substrates while the last two coating zones 300b and 300c are used to sputter the water-sheeting coating 20 on the exterior surface 12 of the substrates.

The arrangement of targets in the multiple-zone sputtering chamber 300 of Figure 5 is merely illustrative and it should be understood that the target arrangement can be varied to maximize production efficiency for different products. For example, if a thicker water-sheeting coating is desired at the same glass speed, a silicon-containing target can be mounted on each of the lower target mounts 361-366 while none of the upper target mounts 321-326 carry a target. If a thinner coating will suffice (or if glass speed through the coating chamber is suitably reduced), only the last two lower target mounts 325 and 326 can be provided with targets while each of the first four upper target mounts 321-324 carry sputtering targets. Of course, any one or more of the coating zones 300a-300c can be operated much like the dual-direction sputtering chamber 200 of Figure 4 by mounting targets in the upper and lower target mounts of the same zone.

The apparatus of Figures 4 and 5 and the method of depositing coatings using such coating systems is discussed in the present application primarily in the context of applying a reflective film stack on one side of the glass and a water-sheeting coating on the other side of the glass. It is to be understood, however, that this apparatus and method can be used to apply coatings to both sides of a pane of glass regardless of the nature of the coatings applied thereto. For example, the apparatus can be used to apply an anti-reflective coating on both sides of a pane of glass, to apply infrared reflective coatings to both sides of a transparent or translucent organic substrate, or to apply a water-sheeting coating to each side of the same substrate.

The advantage of the systems illustrated in Figures 4 and 5 is that a substrate can be provided with a sputtered coating (regardless of composition) on both sides in a single pass through the coating apparatus while the glass is maintained in a constant orientation, i.e. wherein it does not need to be flipped, turned or otherwise manipulated. This enables the use of a simple set of standard transport rollers to move the glass along the production line. In the absence of the present invention, one typically would have to either manually handle the glass to flip it and send it back through the coating apparatus in a separate run, or use a complex glass handling system which must hold the substrate and flip it at some point during the production process. This enables glass having coatings on both sides to be produced particularly economically without any loss in coating quality.

In the past, it was assumed that even if one were to coat the bottom side of the glass, contact with the rollers would mar that coating or and/or damage the bottom surface of the glass prior to application of the coating. Surprisingly, however, the present invention demonstrates that both sides of the glass can be coated in a single pass with excellent results.

The precise operating conditions (e.g. target composition, plasma composition, etc.) under which the water-sheeting coating is applied can be varied as necessary to optimize the deposition of a coating of the desired thickness. Given the present teaching as a guide, one of ordinary skill in the art should be able to select suitable operating conditions to apply this coating without undue experimentation.

A layer of SiO₂ may be sputter deposited using a silicon dioxide target in an inert atmosphere, but silica is a poor conductor and it can be difficult to sputter such dielectric materials in a DC sputtering apparatus. One could instead use a pure silicon target in an oxidizing atmosphere, but such targets are difficult to sputter in a consistent, controlled fashion because silicon is a semiconductor. To improve sputtering and reduce arcing, it is preferred that a target comprising silicon with about 5% aluminum be sputtered in an oxidizing atmosphere.

Even if an aluminum-doped silicon target is employed, the atmosphere in the sputtering chamber can be varied to achieve the optimum sputtering rate. While the sputtering atmosphere should be oxidizing, it need not be pure oxygen. To the contrary, a mixture of oxygen and an inert gas will enhance the sputtering rate. It is believed that a sputtering gas comprising oxygen and up to about 40% argon (preferably 0-20% argon) maintained at about 3 x 10-3 mbar will suffice. The power applied to the sputtering target should be optimized to reduce arcing yet maximize sputtering rate. A power of up to about 80 kW should yield acceptable results.

One manufacturing arrangement which has been found to work well utilizes three rotary sputtering targets of silicon doped with about 5% aluminum, with a power of about 42 kW being applied to each target. The atmosphere in the sputtering chamber comprises 100% O₂ at a pressure of about 2.5-4.5 mTorr (about 3.3 to 6.0 Pa). The glass substrate is moved past these sputtering targets at about 225-500 inches per minute (about 0.1 to 0.2 ms⁻¹).

While a preferred embodiment of the present invention has been described, it should be understood that various changes, adaptations and modifications may be made therein without departing from the scope of the appended claims.

## Claims

1. A method of coating two sides of a single pane of glass (10) in a single pass through a coating apparatus, comprising:
providing a sheet of glass (10) having a clean interior surface (14) and a clean exterior surface (12);
providing a sputtering line comprising at least one sputtering chamber (200; 300a-c), the sputtering line having a plurality of transport rollers (210; 310) for conveying the sheet of glass (10) along the sputtering line, the sputtering line having an upper target (220a, 220b; 320a, 320b) positioned above the transport rollers (210; 310), and a lower target (260; 320c, 320d, 320e, 320f) positioned below the transport rollers (210; 310);
positioning the sheet of glass (10) on the transport rollers (210; 310) such that the interior surface (14) is oriented toward the upper target (220a, 220b; 320a, 320b) and sputtering the upper target (220a, 220b; 320a, 320b) to deposit a coating directly on one of the interior surface (14) of the glass (10) or a film stack layer previously deposited on the interior surface of the glass (14);
positioning the sheet of glass (10) on the transport rollers (210; 310) such that the exterior surface (12) is oriented toward the lower target (260; 320c, 320d, 320e, 320f) and sputtering the lower target (260; 320c, 320d, 320e, 320f) to deposit a coating on one of the exterior surface (12) of the glass (10) or a film stack layer previously deposited on the exterior surface of the glass (10),
the glass (10) being coated on both the interior surface (14) and the exterior surface (12) while maintaining a constant orientation wherein the interior surface (14) is positioned above the exterior surface (12).

2. A method according to Claim 1, wherein the sputtering line comprises a series of sputtering chambers (330a, 330b, 330c), the series of sputtering chambers (330a, 330b, 330c) including a first, downward sputtering chamber (300a) including the upper target (320a, 320b), and a second, upward sputtering chamber (300b, 300c) including the lower target (320c, 320d, 320e, 320f), and in which the sputtering of the upper target (320a, 320b) is performed while the sheet of glass (10) is in the downward sputtering chamber (300a) and the sputtering of the lower target (320c, 320d, 320e, 320f) is performed while the sheet of glass (10) is in the upward sputtering chamber (300b, 300c).

3. A method according to Claim 1, in which the sputtering line includes a dual direction sputtering chamber (200) comprising both the upper and lower targets (220a, 220b,260), and in which while the glass sheet (10) remains in the dual direction sputtering chamber (200), the sputtering of both the upper target (220a, 220b) and the lower target (260) is performed.

4. A method according to any one of the preceding claims, in which the lower target (260; 320c, 320d, 320e, 320f) is sputtered upwardly between the transport rollers.

5. A method according to Claim 4, in which the glass sheet (10) is conveyed over the transport rollers (210; 310) such that the coating of the exterior surface (12) of the glass sheet (10) comes into direct contact with the transport rollers (210; 310).

6. A method according to any one of the preceding claims, wherein the lower target (260; 320c, 320d, 320e, 320f) comprises silicon, said lower target (260; 320c, 320d, 320e, 320f) being sputtered in an oxidizing atmosphere to deposit a water-sheeting coating directly on the exterior surface (12) of the glass (10).

7. A coating apparatus for coating two sides of a single pane of glass (10) in a single pass through the coating apparatus, the coating apparatus comprising a sputtering line that includes at least one sputtering chamber, the sputtering line having a plurality of transport rollers (210; 310) for supporting and conveying the pane of glass (10) along the sputtering line, an upper target (220; 320a, 320b) positioned above the transport rollers (210; 310) within a sputtering chamber (200; 300a) of the sputtering line for sputtering a coating onto the upper surface (14) of the pane of glass (10) and a lower target (260; 360c, 360d, 360e, 360f) positioned below the transport rollers (210; 310) within a sputtering chamber (200; 300b, 300c) of the sputtering line for sputtering a coating onto the lower surface (12) of the pane of glass (10).

8. A coating apparatus according to Claim 7, in which the upper target (220) and the lower target (260) are provided in a single sputter chamber (200).

9. A coating apparatus according to Claim 7, in which the upper target (320a, 320b) is provided in a first sputter chamber (300a) and the lower target (320c, 320d, 320e, 320f) is provided in a second sputter chamber (300b, 300c).

10. A coating apparatus according to any one of claims 7 to 9, further comprising additional sputtering chambers (300b, 300c) each including an upper or lower target (320c, 320d, 320e, 320f) provided above or below the support (210; 310) respectively.

## Patentansprüche

1. Verfahren zum Beschichten zweier Seiten einer einzelnen Glasscheibe oder Glasplatte (10) in einem einzigen Durchgang durch eine Beschichtungsvorrichtung, umfassend:
Lieferung einer Glasplatte (10) mit einer sauberen inneren Oberfläche (14) und einer sauberen äußeren Oberfläche (12);
Einrichtung einer Sputtering-Linie aus mindestens einer Sputtering-Kammer (200;300a bis c), wobei die Sputtering-Linie eine Anzahl Transportwalzen (210 ; 310) zum Transportieren der Glasplatte (10) entlang der Sputtering-Linie sowie ein oberes Target (220a, 220b; 320a, 320b), welches oberhalb de Transportwalzen (210 ; 310) angeordnet ist, und ein unteres Target 260, 320c, 320d, 320e, 320f), welches unterhalb der Transportwalzen (210 ; 310) angeordnet ist, aufweist;
Anordnung der Glasplatte (10) auf den Transportwalzen (210;310) derart, daß die innere Oberfläche (14) auf das obere Target (220a,220b;320a,320b) hin gerichtet ist, und Sputtern des oberen Targets (220a,220b;320a,320b), um unmittelbar auf die innere Oberfläche (14) des Glases (10) oder auf eine auf der inneren Oberfläche des Glases (14) zuvor aufgebrachte Schicht aus einem Stapel von Überzügen eine Beschichtung abzuscheiden;
Anordnung der Glasplatte (10) auf den Transportwalzen (210;310) derart, daß die äußere Oberfläche (12) auf das untere Target(260;320c,320d,320e,320f) hin gerichtet ist, und Sputtern des unteren Targets (260;320c,320d, 320e, 320f), um auf der äußeren Oberfläche (12) des Glases (10) oder auf einer zuvor auf der äußeren Oberfläche des Glases (10) aufgebrachten Schicht aus einem Stapel von Überzügen eine Beschichtung abzuscheiden;
wobei das Glas (10) sowohl auf der inneren Oberfläche (14) als auch der äußeren Oberfläche (12) beschichtet wird, während eine konstante Ausrichtung aufrecht erhalten wird, bei der die innere Oberfläche (14) oberhalb der äußeren Oberfläche (12) angeordnet ist.

2. Verfahren gemäß Anspruch 1, wobei die Sputtering-Linie eine Reihe von Sputtering-Kammern (300a,300b,300c) umfaßt und die Reihe von Sputtering-Kammern (300a, 300b, 300c) eine erste, nach unten gerichtete Sputtering-Kammer (300a) mit dem oberen Target (320a,320b) sowie eine zweite, nach oben gerichtete Sputtering-Kammer (300b,300c) mit dem unteren Target (320c,320d,320e,320f) umfaßt, das Sputtering des oberen Targets (320a,320b) durchgeführt wird, während sich die Glasplatte (10) in der nach unten gerichteten Sputtering-Kammer (300a) befindet, und das Sputtering des unteren Targets (320c,320d,320e,320f) durchgeführt wird, während sich die Glasplatte (10) in der nach oben gerichteten Sputtering-Kammer (300b,300c) befindet.

3. Verfahren gemäß Anspruch 1, wobei die Sputtering-Linie eine Doppelrichtungs-Sputtering-Kammer (200) mit sowohl dem oberen als auch dem unteren Target (220a,220b;260) aufweist und, während sich die Glasplatte (10) in der Doppelrichtungs-Sputtering-Kammer (200) befindet, das Sputtering sowohl des oberen Targets (220a,220b) als auch des unteren Targets (260) durchgeführt wird.

4. Verfahren gemäß einem der vorhergehenden Ansprüche, wobei das untere Target (260;320c,320d,320e,320f) zwischen die Walzen nach oben gesputtert wird.

5. Verfahren gemäß Anspruch 4, wobei die Glastafel (10) derart über die Walzen (210 ; 310) geführt wird, daß die Beschichtung der äußeren Oberfläche (12) der Glastafel (10) in unmittelbare Berührung mit den Walzen (210;310) gelangt.

6. Verfahren gemäß einem der vorhergehenden Ansprüche, wobei das untere Target (260;320c,320d,320e,320f) Silizium umfaßt und in einer oxidierenden Atmosphäre dem Sputtering unterworfen wird, um eine Wasser zum Ablaufen bringende Beschichtung unmittelbar auf die äußere Oberfläche (12) des Glases (10) abzuscheiden.

7. Beschichtungsvorrichtung zum Beschichten beider Seiten einer einzelnen Glastafel (10) in einem einzigen Durchgang durch die Vorrichtung, umfassend eine Sputtering-Linie mit mindestens einer Sputtering-Kammer, wobei die Sputtering-Linie eine Anzahl Transportwalzen (210;310) zum Haltern und Transportieren der Glastafel (10) entlang der Sputtering-Linie, ein oberes Target (220,320a, 320b), welches oberhalb des Transportwalzen (210;310) innerhalb einer Sputtering-Kammer (200;300a) zum Aufbringen eines Überzuges auf die obere Oberfläche (14) der Glastafel (10) durch Sputtering angeordnet ist, und ein unteres Target (260;320c,320d,320e,320f) aufweist, welches unterhalb der Transportwalzen (210; 310) innerhalb einer Sputtering-Kammer (200 ; 300b, 300c) zum Aufbringen einer Beschichtung auf die untere Oberfläche (12) der Glastafel (10) angeordnet ist.

8. Beschichtungsvorrichtung gemäß Anspruch 7, wobei das obere Target (220) und das untere Target (260) in einer einzigen Sputtering-Kammer (200) angeordnet sind.

9. Beschichtungsvorrichtung gemäß Anspruch 7, wobei das obere Target (320a,320b) in einer ersten Sputtering-Kammer (300a) und das untere Target (320c,320d, 320e, 320f) in einer zweiten Sputtering-Kammer (300b,300c) an geordnet ist.

10. Beschichtungsvorrichtung gemäß einem der Ansprüche 7-9, weiterhin umfassend zusätzliche Sputtering-Kammern (300b,300c), von denen jede ein oberes oder unteres Target (320c,320d,320e,320f) enthält und die oberhalb bzw. unterhalb der Transportwalzen (210;310) angeordnet sind.

## Revendications

1. Procédé de recouvrement des deux faces d'une plaque de verre unique (10) en une passe unique par un appareil de revêtement, comprenant :
la fourniture d'une plaque de verre (10) comportant une surface intérieure propre (14) et une surface extérieure propre (12) ;
la fourniture d'une ligne de pulvérisation comportant au moins une chambre de pulvérisation (200 ; 300a-c), la ligne de pulvérisation ayant plusieurs rouleaux de transport (210 ; 310) pour déplacer la plaque de verre (10) le long de la ligne de pulvérisation, la ligne de pulvérisation ayant une cible supérieure (220a, 220b ; 320a, 320b) positionnée au-dessus des rouleaux de transport (210 ; 310) et une cible inférieure (260 ; 320c, 320d, 320e, 320f) positionnée au-dessous des rouleaux de transport (210 ; 310) ;
le positionnement de la plaque de verre (10) sur les rouleaux de transport (210 ; 310) de telle sorte que la surface intérieure (14) est orientée vers la cible supérieure (220a, 220b ; 320a, 320b), et la pulvérisation de la cible supérieure (220a, 220b ; 320a, 320b) pour déposer un revêtement directement sur une surface intérieure (14) du verre (10) ou une couche formée d'un empilement de films déposée au préalable sur la surface intérieure du verre (14) ;
le positionnement de la plaque de verre (10) sur les rouleaux de transport (210; 310) de telle sorte que la surface extérieure (12) est orientée vers la cible inférieure (260 ; 320c, 320d, 320e, 320f), et la pulvérisation de la cible inférieure (260 ; 320c, 320d, 320e, 320f) pour déposer un revêtement sur une surface extérieure (12) du verre (10) ou une couche formée d'un empilement de films déposée au préalable sur la surface extérieure du verre (10) ;
le verre (10) étant revêtu tant sur la surface intérieure (14) que sur la surface extérieure (12) en maintenant une orientation constante dans laquelle la surface intérieure (14) est positionnée au-dessus de la surface extérieure (12).

2. Procédé selon la revendication 1, dans lequel la ligne de pulvérisation comprend une série de chambres de pulvérisation (330a, 330b, 330c), la série de chambres de pulvérisation (330a, 330b, 330c) comprenant une première chambre de pulvérisation vers le bas (300a) incluant la cible supérieure (320a, 320b), et une seconde chambre de pulvérisation vers le haut (300b, 300c) incluant la cible inférieure (320c, 320d, 320e, 320f), et dans laquelle la pulvérisation de la cible supérieure (320a, 320b) est réalisée alors que la plaque de verre (10) se trouve dans la chambre de pulvérisation vers le bas (300a) et la pulvérisation de la cible inférieure (320c, 320d, 320e, 320f) est réalisée alors que la plaque de verre (10) se trouve dans la chambre de pulvérisation vers le haut (300b, 300c).

3. Procédé selon la revendication 1, dans lequel la ligne de pulvérisation comprend une chambre de pulvérisation dans les deux sens (200) comportant à la fois des cibles supérieure et inférieure (200a, 200b, 260), et dans lequel, tandis que la plaque de verre (10) reste dans la chambre de pulvérisation dans les deux sens (200), la pulvérisation à l'aide de la cible supérieure (220a, 220b) et de la cible inférieure (260) est réalisée.

4. Procédé selon l'une quelconque des revendications précédentes, dans lequel la cible inférieure (260 ; 320c, 320d, 320e, 320f) est pulvérisée vers le haut entre les rouleaux de transport.

5. Procédé selon la revendication 4, dans lequel la plaque de verre (10) est transportée sur les rouleaux de transport (210 ; 310) de façon telle que le revêtement de la surface extérieure (12) de la plaque de verre (10) vient en contact direct avec les rouleaux de transport (210 ; 310).

6. Procédé selon l'une quelconque des revendications précédentes, dans lequel la cible inférieure (260 ; 320c, 320d, 320e, 320f) comprend du silicium, ladite cible inférieure (260 ; 320c, 320d, 320e, 320f) étant pulvérisée dans une atmosphère oxydante pour déposer un revêtement d'étalement de l'eau directement sur la surface extérieure (12) du verre (10).

7. Appareil de revêtement destiné à revêtir les deux faces d'une plaque de verre unique (10) en une passe unique par l'appareil de revêtement, l'appareil de revêtement comprenant une ligne de pulvérisation qui comprend au moins une chambre de pulvérisation, la ligne de pulvérisation comprenant plusieurs rouleaux de transport (210 ; 310) destinés à supporter et déplacer la plaque de verre (10) le long de la ligne de pulvérisation, une cible supérieure (220 ; 320a, 320b) positionnée au-dessus des rouleaux de transport (210 ; 310) au sein d'une chambre de pulvérisation (200 ; 300a) de la ligne de pulvérisation pour pulvériser un revêtement sur la surface supérieure (14) de la plaque de verre (10), et une cible inférieure (260 ; 320c, 320d, 320e, 320f) positionnée au-dessous des rouleaux de transport (210 ; 310) au sein d'une chambre de pulvérisation (200 ; 300b ; 300c) de la ligne de pulvérisation pour pulvériser un revêtement sur la surface inférieure (12) de la plaque de verre (10).

8. Appareil de revêtement selon la revendication 7, dans lequel la cible supérieure (220) et la cible inférieure (260) sont prévues dans une chambre de pulvérisation unique (200).

9. Appareil de revêtement selon la revendication 7, dans lequel la cible supérieure (320a, 320b) est prévue dans une première chambre de pulvérisation (300a) et la cible inférieure (320c, 320d, 320e, 320f) est prévue dans une seconde chambre de pulvérisation (300b, 300c).

10. Appareil de revêtement selon l'une quelconque des revendications 7 à 9, comprenant en outre des chambres de pulvérisation supplémentaires (300b, 300c) comportant chacune une cible supérieure ou inférieure (320c, 320d, 320e, 320f), prévue respectivement au-dessus ou au-dessous des rouleaux de transport (210 ; 310).
